# EUROPEAN PATENT APPLICATION

(11) **EP 4 254 517 A1**
(43) Date of publication of application: **04.10.2023**
(21) Application number: 22908852.1
(22) Date of filing: 27.07.2022
(51) Int. Cl.: H01L 31/18, H01L 21/02, H01L 31/0216, H01L 31/068, C23C 16/40

(54) **TUNNELING OXIDE LAYER, N-TYPE DOUBLE-SIDED SOLAR CRYSTALLINE SILICON BATTERY, AND PREPARATION METHODS**

(30) Priority: 30.12.2021 CN 202111650174
(71) Applicant: Tongwei Solar (Meishan) Co., Ltd., Meishan, Sichuan 620041 (CN)
(72) Inventor: ZHANG, Ming, Meishan City, Sichuan 620041 (CN); MENG, Xiajie, Meishan City, Sichuan 620041 (CN); XU, Wenzhou, Meishan City, Sichuan 620041 (CN); CHEN, Hao, Meishan City, Sichuan 620041 (CN); DENG, Mingzhang, Meishan City, Sichuan 620041 (CN); XING, Guoqiang, Meishan City, Sichuan 620041 (CN); YAO, Qian, Meishan City, Sichuan 620041 (CN)
(74) Representative: Marks & Clerk LLP
(86) International application number: PCT/CN2022/108295
(87) International publication number: WO 2023/124046

(57) **Abstract**

A tunnel oxide layer, an N-type bifacial crystalline silicon solar cell and a method for manufacturing the same are provided, which are relate to the field of crystalline silicon solar cells. The method for manufacturing the tunnel oxide layer includes forming excess -OH on a back side of a silicon wafer, and depositing the tunnel oxide layer on the back side of the silicon wafer by a Plasma Enhanced Atomic Layer Deposition method. The method for manufacturing the N-type bifacial crystalline silicon solar cell can include following steps: performing cleaning, texturing, boron diffusing, and alkaline polishing on an N-type silicon wafer, sequentially forming a P-type doped layer, a passivation layer, and an anti-reflection layer on a front side of the alkaline-polished N-type silicon wafer, and forming a tunnel oxide layer on a back side of the alkaline-polished N-type silicon wafer, followed by forming an N-type doped polysilicon layer, and after annealing, forming an anti-reflection layer. A SiOₓ layer obtained by the above method can be continuous and dense, and have a fast growth rate, an excellent impurity absorption effect and an excellent blocking effect. Moreover, a thickness of the SiOₓ layer can be accurate and controllable, and the SiOₓ layer has pinholes with a high density and a large size after high temperature annealing.

## Description

### CROSS-REFERENCE TO RELATED APPLICATIONS

This application claims priority to Chinese Patent Application No. 202111650174.9, filed on December 30, 2021, and entitled "TUNNEL OXIDE LAYER, N-TYPE BIFACIAL CRYSTALLINE SILICON SOLAR CELL AND METHOD FOR MANUFACTURING THE SAME" in the China National Intellectual Property Administration, the content of which is hereby incorporated by reference in its entirety.

### TECHNICAL FIELD

The present application relates to the field of crystalline silicon solar cells, and in particular, to a tunnel oxide layer, an N-type bifacial crystalline silicon solar cell and a method for manufacturing the same.

### BACKGROUND

In recent years, efficiency of crystalline silicon solar cells has been greatly improved by a passivated contact structure with an ultra-thin SiOₓ layer, and a heavy doping polysilicon. The ultra-thin SiOₓ layer has an extremely low interface state density, a certain chemical passivation effect, saturated silicon surface dangling bonds, and an ability of selective electron collection due to an electron trapping ability of holes and electrons which is highly asymmetric (a hole barrier is greater than an electron barrier). Studies have further shown that the SiOₓ layer can effectively prevent heavy metal impurity atoms from entering a silicon region from a polysilicon layer, and the SiOₓ layer has a blocking and impurity absorption effect.

At present, the SiOₓ layer can be mainly prepared by a wet chemical growth method (e.g., a wet chemical growth method with a hot nitric acid), a thermal oxidation growth method (e.g., an oxidative growth method with hot nitric acid), a Plasma Enhanced Chemical Vapor Deposition (PECVD) method, and an Atomic Layer Deposition (ALD) method. A preparation process of the SiOₓ layer by the thermal oxidation growth method is very slow, which is not conducive to industrial production. A deposition rate of the SiOₓ layer prepared by the PECVD method is too fast, it is difficult to accurately control the deposition of the SiOₓ layer, so it is difficult to control a thickness of the SiOₓ layer within an ultra-thin range. The SiOₓ layers prepared by the wet chemical growth method and the PECVD method have a low stoichiometric ratio of Si⁴⁺, a weak blocking effect, a weak impurity absorption effect and a poor thermal stability. The SiOₓ layer prepared by the ALD method is poor in density, high in surface state density and low in passivation performance. Therefore, pinholes with a high density and a large size cannot be obtained, which is not conducive to reducing contact resistance. Moreover, the SiOₓ layer prepared by the ALD method is required to be deposited at a high temperature, and preparation time of the SiOₓ layer is long, which is not conducive to industrial production.

### SUMMARY

The present application is aim to provide a tunnel oxide layer, an N-type bifacial crystalline silicon solar cell and a method for manufacturing the same. A SiOₓ layer provided by the present application can be continuous and dense, and have a fast growth rate, an excellent impurity absorption effect and an excellent blocking effect. Moreover, a film thickness of the SiOₓ layer can be accurate and controllable, and the SiOₓ layer has pinholes with a high density and a large size after high temperature annealing.

In some embodiments, the present application provides a method for manufacturing a tunnel oxide layer. The method includes forming excess -OH on a back side of a silicon wafer, and depositing a tunnel oxide layer on the back side of the silicon wafer by a Plasma Enhanced Atomic Layer Deposition (PEALD) method.

In the above technical solution, the excess -OH can be first formed on the front side of the silicon wafer, so as to provide -OH for preparation of the SiOₓ tunnel oxide layer by the PEALD method. Shortcomings of the ALD method can be overcome by the PEALD method. In the PEALD method, a silicon precursor and an oxygen source can react atomically in an electric field generated by a radio frequency power supply. Specifically, the oxygen source is ionized into a plasma. The plasma has high energy and activity, and quickly reacts with a silicon atom adsorbed on the silicon wafer to generate a SiOₓ film. The SiOₓ film prepared by the PEALD method has high purity, and includes a single component of SiO₂ (a complex ratio of Si and O is 1 : 2). The SiOₓ film is excellent in density, and a thickness of the SiOₓ film can be accurately controlled at a nanometer level. The SiOₓ film has a high stoichiometric ratio of Si⁴⁺, the strong blocking effect, the strong impurity absorption effect and thermal stability, few additional oxygen atoms, and low interface state density. Furthermore, the thickness of the SiOₓ film can be accurately controlled, and can withstand high-temperature annealing. The SiOₓ film has pinholes with the high density and the large size after high temperature annealing, and uniformity of the pinholes can be ensured. In addition, coverage of silicon precursor during the PEALD method can be improved by the -OH, thus ensuring to form a dense, continuous SiO₂ film and reducing cost of an organosilicon source.

In some embodiments, the forming excess -OH includes cleaning the silicon wafer by using an alkaline solution during an alkaline polishing process after boron diffusing. And the alkaline solution is prepared by mixing NaOH or KOH with H₂O₂.

In the above technical solution, the excess -OH can be formed on the back side of the silicon wafer by the alkaline polishing process after boron diffusing. In this way, the coverage of silicon precursor can be improved, so as to form the dense and continuous SiO₂ film.

In some embodiments, the Plasma Enhanced Atomic Layer Deposition method further includes following steps:
51, introducing a silicon precursor to adsorb silicon atoms on the back side of the silicon wafer, followed by argon gas purging to remove excess silicon atoms, leaving a layer of silicon atoms adsorbed on the back side of the silicon wafer;
S2, introducing an oxygen source and, under an influence of an electric field generated by a radio frequency power supply, depositing a SiOₓ film on the back side of the silicon wafer; and
S3, repeating steps S1 and S2 to form the tunnel oxide layer.

In the above technical solution, firstly, the silicon precursor can be introduced on the front side of the silicon wafer to adsorb silicon atoms, excess silicon atoms can be removed by purging of the argon gas, and a layer of silicon atoms adsorbed on the front side of the silicon wafer can be retained. Secondly, the oxygen source can be introduced, under the influence of the electric field generated by the radio frequency power supply, the oxygen source can be ionized into the plasma and quickly react with the silicon atoms adsorbed on the silicon wafer to form the SiOₓ film. The tunnel oxide layer applied in the crystalline silicon solar cell can be prepared precisely after several cycles of repeating the steps S1 and S2.

In some embodiments, the radio frequency power supply is a square wave or a sine wave power supply with a frequency of 40 kHz to 400 kHz.

Different from high frequency power supply with a frequency magnitude of MHz or GHz that changes very rapidly and causes abrupt changes, the radio frequency power supply in the above technical solution belongs to low-medium frequency range, with slow signal variation and smooth waveform. Therefore, the uniformity of the SiOₓ film formed by the present application can be better. And the SiOₓ film can be formed with the single component of SiO₂, and the SiOₓ film has high stoichiometric ratio of Si⁴⁺, excellent blocking effect, impurity absorption effect and thermal stability.

In some embodiments, a deposition temperature of depositing the SiOₓ film is in a range of 80 °C to 400 °C.

In the above technical solution, the range of the deposition temperature can be wide and low, so that a tunnel oxide layer with great passivation performance can be prepared. Furthermore, the low-temperature deposition is conducive to reducing electricity consumption and manufacturing costs, that is, the PEALD method can be performed at a wide range of temperatures and the SiOₓ film can be deposed at low temperature, reducing energy consumption.

In some embodiments, the silicon precursor is an organosilicon source (TMA) or a silane (SiH₄), and the oxygen source is oxygen (O₂) or nitrous oxide (N₂O).

In the above technical solution, the organosilicon source and the silane can be typical silicon precursors, and the oxygen and the nitrous oxide can be typical oxygen source.

In some embodiments, the number of depositing the SiOₓ film is 1 to 400 times, and/or, a thickness of the tunnel oxide layer is in a range of 1 nm to 2 nm.

In the above technical solution, the number of depositing the SiOₓ film can be controlled to obtain the tunnel oxide layer with an obvious multilayer structure. Moreover, a structure and properties of polycrystalline/amorphous silicon can be affected by adjusting a preparation process of interface of SiOₓ.

Some other embodiments of the present embodiment further provide a method for manufacturing an N-type bifacial crystalline silicon solar cell, including following steps:
performing cleaning, texturing, boron diffusing, and alkaline polishing on an N-type silicon wafer;
sequentially forming a P-type doped layer, a passivation layer, and an anti-reflection layer on a front side of the alkaline-polished N-type silicon wafer; and
forming a tunnel oxide layer on a back side of the alkaline-polished N-type silicon wafer by using the above method for manufacturing a tunnel oxide layer, followed by forming an N-type doped polysilicon layer, and after annealing, forming an anti-reflection layer.

In the above technical solution, under the influence of the electric field generated by the radio frequency power supply, the SiOₓ film have a fast growth rate, thereby improving a utilization rate of facilities and facilitating industrialization and low-cost production of the N-type bifacial crystalline silicon solar cell. The tunnel oxide layer has pinholes with the high density and the large size after high temperature annealing, which can effectively improve selectivity of electron transmission. In addition, the tunnel oxide layer has low surface state density and contact resistance after high temperature annealing, which can greatly improve conversion efficiency of the N-type bifacial crystalline silicon solar cell.

In some embodiments, the method further includes forming a front electrode on the anti-reflection layer located on the front side of the N-type silicon wafer and a back electrode on the anti-reflection layer located on the back side of the N-type silicon wafer.

In some embodiments, an annealing temperature is in a range of 850 °C to 1100 °C.

In the above technical solution, the tunnel oxide layer has pinholes with the high density and the large size after high temperature annealing.

In some embodiments, a method of alkaline polishing includes: sequentially performing pre-cleaning, rinsing, etching, rinsing, alkali washing, rinsing, acid washing, and rinsing. An alkali solution is used in the alkali washing, the alkali solution is prepared by mixing NaOH or KOH with H₂O₂ with a volume ratio of 1:9 to 1:10, and a temperature of the alkali washing is in a range of 45 °C to 55 °C.

In the above technical solution, the specific alkaline polishing process enables formation of excess -OH on the front side of the silicon wafer simultaneously.

In some embodiments, the passivation layer on a front side of the P-type doped layer is made of aluminum oxide deposited by using Plasma-Enhanced Atomic Layer Deposition (PEALD) method. And a radio frequency power supply of PEALD is a frequency of 40 kHz, and a deposition temperature of PEALD is 430 °C.

In some embodiments, the anti-reflection layer includes multi layers containing silicon nitride with different refractive indexes, which are deposited using Plasma-Enhanced Chemical Vapor Deposition (PECVD) method on a front side of the passivation layer made of aluminum oxide.

In some embodiments, the anti-reflection layer includes silicon nitride and is prepared on a back side of the N-type doped polysilicon layer.

In some embodiments, the front electrode is formed on the anti-reflection layer located on the front side of the N-type silicon wafer by printing a silver-aluminum paste. And the back electrode is formed on the anti-reflection layer located on the back side of the N-type silicon wafer.

Some other embodiments of the present embodiment further provides an N-type bifacial crystalline silicon solar cell, including: an N-type silicon wafer, a P-type doped layer, a passivation layer, and an anti-reflection layer sequentially stacked on a front side of the N-type silicon wafer, and a tunnel oxide layer, an N-type doped polysilicon layer, and an anti-reflection layer sequentially stacked on a back side of the N-type silicon wafer. And the tunnel oxide layer is manufactured by the above method for manufacturing the tunnel oxide layer.

In the above technical solution, the N-type bifacial crystalline silicon solar cell has high conversion efficiency.

### BRIEF DESCRIPTION OF THE DRAWINGS

In order to more clearly illustrate the technical solutions in the embodiments of the present application, the following will briefly describe the accompanying drawings used in the description of the embodiments. It is obvious that the accompanying drawings in the following description are only some embodiments of the present application, but are not to be construed as limiting the scope of the application. For those of ordinary skill in the art, other drawings can be obtained according to these accompanying drawings without creative work.

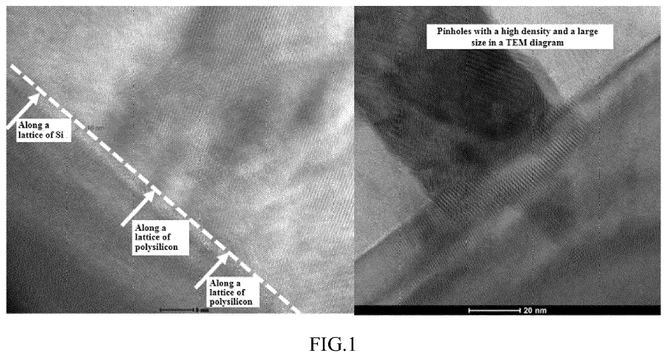

FIG. 1 is a transmission electron microscope (TEM) diagram of a tunnel oxide layer in embodiment 1 of the present application.

### DETAILED DESCRIPTION

In a process of realizing the present application, it can be found that passivation quality of a passivation layer made of oxide in a cell depends to a large extent on preparation and an annealing temperature of an interface oxide. Moreover, density, a film thickness and a stoichiometric ratio of Si⁴⁺ of a SiOₓ film have obvious effects on blocking impurity migration, an impurity absorption effect and thermal stability. For the SiOₓ film, electrons can pass through the dense SiOₓ film via a quantum tunneling effect and local pinholes. Therefore, local pinholes with a high density and a large size is conducive to electron transmission and reduction of contact resistance, thereby improving an opening voltage and a short-circuit current of the crystalline silicon solar cell.

At present, the SiOₓ film can be mainly prepared by a wet chemical growth method, a thermal oxidation growth method, a Plasma Enhanced Chemical Vapor Deposition (PECVD) method, and an Atomic Layer Deposition (ALD) method. The above methods have various problems.

A preparation process of the SiOₓ film by the thermal oxidation growth method is very slow, since HNO₃ is required to decompose to provide active oxygen, the preparation process is not conducive to rapid industrial production. A preparation process of the SiOₓ film by PECVD method has been widely applied in a solar industry to inhibit potential induced degradation (PID). However, a deposition rate of the SiOₓ film prepared by a silane (SiH₄) reacting with nitrous oxide gas (N₂O) or oxygen is too fast, it is difficult to accurately control the deposition of the SiOₓ film, so it is difficult to control a thickness of the SiOₓ film within 2 nm. Furthermore, when the thickness of the SiOₓ film exceeds 2 nm, electrons are difficult to tunnel and the current is greatly reduced. The thickness of the tunnel oxide layer is dependent on diffusion energy of the oxygen atoms and becomes self-saturated. The SiOₓ films prepared by the wet chemical growth method with a hot nitric acid and the PECVD method have a low stoichiometric ratio of Si⁴⁺ than that of SiOₓ film prepared by thermal oxidation growth method, a weak blocking effect, a weak impurity absorption effect and poor thermal stability. The SiOₓ films prepared by the wet chemical growth method with the hot nitric acid cannot withstand the high annealing temperature. Moreover, the excess oxygen source will react with silicon atoms again during a high temperature annealing process, so as to increase the thickness of the SiOₓ film. The SiOₓ film prepared by the thermal oxidation growth method has excellent film quality and density, and has good effects in impurity absorption, blocking and thermal stability. However, the thermal oxidation growth method usually has a long preparation time and a high temperature, which is not conducive to large-scale production.

The Atomic Layer Deposition method can be performed by using oxygen or nitrous oxide gas with silane (SiH₄) at a deposition temperature of 200 °C to 500 °C. Taking the oxygen as an example, the specific process can be briefly described as follows: performing a primary adsorption on a substrate surface; the silane reacting with hydroxyl groups on the substrate surface; adsorbing silicon groups on the substrate surface until saturation; pumping away the remaining silane; introducing oxygen to react with the silicon groups to obtain Si-O bridge bonds; and after the substrate surface is passivated by the hydroxyl groups, pumping away the excess oxygen; and repeating the above steps to form a first layer of SiOₓ film. In this way, a first disadvantage is that the SiOₓ film is poor in density, high in surface state density and low in passivation performance. A second disadvantage is that the SiOₓ film is required to be deposited at a high temperature of 200°C to 500°C. A third disadvantage is that preparation time of the SiOₓ film is long, thus reducing a utilization rate and production capacity of facilities, which is unacceptable in industrial production. And a fourth disadvantage is that pinholes with the high density and the large size cannot be achieved, which is not conducive to reducing the contact resistance.

After analyzing various methods and disadvantages for manufacturing the SiOₓ film in the related art, it can be found that main problems of manufacturing the SiOₓ film are as follows. The growth rate of the SiOₓ film is too fast or too slow, the density thereof is poor, the stoichiometric ratio of Si⁴⁺ is low, and the SiOₓ film cannot be annealed at high temperature, so that pinholes with the high density and the large size cannot be obtained.

In order to make objects, technical solutions and advantages of the present application more clearly understood, the technical solutions in the embodiments of the present application are clearly and completely described in the following. The specific conditions without indicating in the embodiments shall be performed in accordance with the general conditions or the conditions recommended by a manufacturer. The reagents or instruments used without indicating the manufacturer are conventional products that can be purchased commercially.

The tunnel oxide layer, an N-type bifacial crystalline silicon solar cell and a method for manufacturing the same in the present application are specifically described below.

Some embodiments of the present application provide a method for manufacturing the tunnel oxide layer. The method includes forming excess -OH on a back side of a silicon wafer, and depositing a tunnel oxide layer on the back side of the silicon wafer by a Plasma Enhanced Atomic Layer Deposition method. The forming excess -OH includes cleaning the silicon wafer by using an alkaline solution during an alkaline polishing process after boron diffusing. The alkaline solution is prepared by mixing NaOH or KOH with H₂O₂.

The Plasma Enhanced Atomic Layer Deposition method can further include following steps:
51, introducing a silicon precursor to adsorb silicon atoms on the back side of the silicon wafer, followed by argon gas purging to remove excess silicon atoms, leaving a layer of silicon atoms adsorbed on the back side of the silicon wafer, wherein the silicon precursor is an organosilicon source or a silane;
S2, introducing an oxygen source and, under an influence of an electric field generated by a radio frequency power supply, depositing a SiOₓ film on the back side of the silicon wafer, wherein the oxygen source being oxygen or nitrous oxide, the radio frequency power supply is a square wave or a sine wave power supply with a frequency of 40 kHz to 400 kHz, a deposition temperature of depositing the SiOₓ film is in a range of 80 °C to 400 °C; and
S3, repeating steps S1 and S2 to form the tunnel oxide layer.

Generally, the number of depositing the SiOₓ film can be 1 to 400 times, and a corresponding thickness of the tunnel oxide layer can be in a range of 1 nm to 2 nm.

Some embodiments of the present embodiment further provides an N-type bifacial crystalline silicon solar cell, including: a silicon wafer, a passivation layer, an anti-reflection layer, and a front electrode sequentially stacked on a front side of the silicon wafer; and a tunnel oxide layer, a doped polysilicon layer, an anti-reflection layer, and a back electrode sequentially stacked on a back side of the silicon wafer. And the tunnel oxide layer is manufactured by the above-mentioned method for manufacturing the tunnel oxide layer.

It should be noted that the silicon wafer in the present embodiment can be an N-type silicon wafer. A geometric dimension and a specification shape of the silicon wafer are not limited. The tunnel oxide layer is located between the back of the N-type silicon wafer and the doped polysilicon layer, which cannot be adjusted.

Furthermore, some embodiments of the present embodiment provide a method for manufacturing an N-type bifacial crystalline silicon solar cell. A Plasma-Enhanced Atomic Layer Deposition (PEALD) device can be applied in the method, and the method includes following steps:
(1) performing cleaning, texturing, boron diffusing, and alkaline polishing on an N-type silicon wafer,
   wherein, a method of alkaline polishing can include: sequentially performing pre-cleaning, rinsing, etching, rinsing, alkali washing, rinsing, acid washing, and rinsing, wherein an alkali solution is used in the alkali washing, the alkali solution is prepared by mixing NaOH or KOH with H₂O₂ with a volume ratio of 1:9 to 1:10, and a temperature of the alkali washing is in a range of 45 °C to 55 °C, so as to form excess -OH on a back side of the N-type silicon wafer;
(2) sequentially forming a P-type doped layer, a passivation layer, and an anti-reflection layer on a front side of the alkaline-polished N-type silicon wafer;
(3) forming a tunnel oxide layer on a back side of the alkaline-polished N-type silicon wafer by using the above method for manufacturing the tunnel oxide layer, followed by forming an N-type doped polysilicon layer, and after annealing, forming an anti-reflection layer, wherein, the tunnel oxide layer is deposited on the back side of the silicon wafer by a Plasma Enhanced Atomic Layer Deposition method, and an annealing temperature is in a range of 850 °C to 1100 °C; and
(4) forming a front electrode on the anti-reflection layer located on the front side of the N-type silicon wafer and a back electrode on the anti-reflection layer located on the back side of the N-type silicon wafer.

It should be noted that in the present embodiment, a form and shape of the PEALD device, and a device manufacturer and use conditions are not limited. For example, the PEALD device may be a tube-type or a plate-type apparatus. Furthermore, a material and shape of a silicon wafer bearing device in the present application are not limited, such as the shape and size of a graphite boat are not limited herein.

The features and performance of the present application are described in further detail below with reference to embodiments.

### Example 1

This example provides an N-type bifacial crystalline silicon solar cell. The N-type bifacial crystalline silicon solar cell is manufactured by the following steps.

In first step, after cleaning an N-type silicon wafer, a front side of the N-type silicon wafer is textured on to reduce light reflection, and boron diffused on the front side of the N-type silicon wafer to obtain boron-containing compounds, forming a P-type doped layer.

In second step, borosilicate glass is removed after boron diffusing including following processes:
Pre-cleaning: pre-cleaning with an alkali solution for 135 seconds under a temperature of 70 °C, and the alkali solution being prepared by mixing NaOH with H₂O₂ with a volume ratio of 1:10;
Rinsing: rinsing with deionized water for 135 seconds;
Etching: etching with NaOH and additives for 460 seconds, and alkaline polishing on a back side of the alkaline-polished N-type silicon wafer;
Rinsing: rinsing with deionized water for 135 seconds;
Alkali washing: cleaning with an alkali solution for 120 seconds under a temperature of 50 °C, and the alkali solution being prepared by mixing NaOH or KOH with H₂O₂ with the volume ratio of 3 : 28;
Rinsing: rinsing with deionized water for 135 seconds;
Acid washing: acid washing with HCl aqueous solution for 120 seconds; and
Rinsing: rinsing with deionized water for 135 seconds.

The excess -OH can be formed by cleaning the silicon wafer with an alkaline solution prepared by mixing NaOH or KOH with H₂O₂, which is conducive to depositing a SiOₓ film by the Plasma Enhanced Atomic Layer Deposition method.

In third step, the aluminum oxide passivation layer is deposited on a front side of the P-type doped layer by the PEALD method, wherein a radio frequency power supply of PEALD is a frequency of 40 kHz, and a deposition temperature of PEALD is 430 °C.

In fourth step, multi anti-reflection layers containing silicon nitride with different refractive indexes are deposited on a front side of the aluminum oxide passivation layer by PECVD method. Specifically, the multi anti-reflection layers include three layers of silicon nitride (refractive index of the three layers of silicon nitride decreases along a direction from inside to outside), a silicon oxynitride layerand a silicon oxide layer.

In fifth step, a SiOₓ tunnel silicon oxide layer is formed on a back side of the N-type silicon wafer by the PECVD method. A thickness of the SiOₓ tunnel silicon oxide layer is 1.5 nm, the radio frequency power supply is a square wave with the frequency of 40 kHz, and the deposition temperature of depositing the SiOₓ tunnel silicon oxide layer is 400 °C. The fifth step can further include forming an intrinsic N-type doped polysilicon layer and an N-type doped polysilicon layer doped by phosphorus-containing compounds, and followed by high temperature at an annealing temperature of 920 °C and RCA cleaning.

FIG. 1 is a transmission electron microscope diagram of the tunnel oxide layer. As shown in FIG. 1, a growing direction of the SiOₓ tunnel silicon oxide layer is along a latticeo of polysilicon, and pinholes with a high density and a large size are obtained.

In sixth step, an anti-reflection layer containing silicon nitride is prepared on a back side of the N-type doped polysilicon layer. Specifically, the anti-reflection layer containing silicon nitride includes four layers of silicon nitride (refractive index of the four layers of silicon nitride decreases along a direction from inside to outside), a silicon oxynitride layer and a silicon oxide layer.

In seventh step, the front electrode is formed on the anti-reflection layer located on the front side of the N-type silicon wafer by printing a silver-aluminum paste, and the back electrode is formed on the anti-reflection layer located on the back side of the N-type silicon wafer.

An iVoc (Implicit Volatile Organic Compound) of the obtained N-type bifacial crystalline silicon solar cell in Example 1 is more than 720 mV, and the conversion efficiency thereof is more than 24.5%.

### Comparative example 1

An N-type bifacial crystalline silicon solar cell is provided in Comparative Example 1. A difference between Example 1 and Comparative Example 1 is in that Comparative Example 1 includes performing polishing without the alkali solution prepared by mixing NaOH or KOH with H₂O₂ with a high volume ratio.

An open circuit voltage of the N-type bifacial crystalline silicon solar cell in Comparative Example 1 is about 705 mV, and the conversion efficiency thereof is about 24%.

### Comparative Example 2

An N-type bifacial crystalline silicon solar cell is provided in Comparative Example 2. A difference between Example 1 and Comparative Example 2 is in that Comparative Example 2 includes reducing a flow rate of a boron source during boron diffusing, reducing the concentration of the boron source, controlling a square resistance at about 100, and without annealing.

An open circuit voltage of the N-type bifacial crystalline silicon solar cell in Comparative Example 2 was about 700 mV, and the conversion efficiency thereof is about 23.7%.

### Comparative Example 3

An N-type bifacial crystalline silicon solar cell is provided in Comparative Example 3. A difference between Example 1 and Comparative Example 3 is in that Comparative Example 3 includes oxidizing the N-type silicon wafer in a hot nitric acid solution with a certain concentration, and without annealing.

An open circuit voltage of the N-type bifacial crystalline silicon solar cell in Comparative Example 3 is about 708 mV, and the conversion efficiency thereof is about 23.9%.

### Comparative Example 4

An N-type bifacial crystalline silicon solar cell is provided in Comparative Example 4. A difference between Embodiment 1 and Comparative Example 4 is that: in the Comparative Example 4, depositing the SiOₓ film at a deposition temperature of 360 °C, introducing the nitrous oxide in a flow rate of 10000 sccm, a power supply of the PECVD method being 10 kW, and the deposition time being 120s.

An open circuit voltage of the N-type bifacial crystalline silicon solar cell in Comparative Example 4 is about 710 mV, and the conversion efficiency thereof is about 24%.

Firstly, comparison data of the cell conversion efficiency are as follows.

At present, most cells are Passivated Emitter and Rear Cells (PERC), and the PERC are different from a structure of the N-type bifacial crystalline silicon solar cell in the present application. Therefore, the conversion efficiency of a cell obtained by a conventional process is mostly less than 24% (i.e., conversion efficiency of the cell is 23%, the opening circuit voltage is less than 710 mV, and a current is less than 18 A). The conversion efficiency of solar cell prepared by the method in the present application can be up to 24.7%.

Secondly, a comparison of the cell surface is as below.

It can be seen from the Example and Comparative Examples that: the number of repeating times in the PEALD method of the present application can be adjusted to prepare a tunnel oxide layer with a controllable thickness; and pinholes with a high density and a large size can be achieved after a high temperature annealing.

In summary, a tunnel oxide layer, an N-type bifacial crystalline silicon solar cell and a method for manufacturing the same are provided in the present application. A SiOₓ layer can be continuous and dense, and have a fast growth rate, an excellent impurity absorption effect and an excellent blocking effect. Moreover, a thickness of the SiOₓ layer can be accurate and controllable, and the SiOₓ layer has pinholes with a high density and a large size after high temperature annealing.

The above description is merely several embodiments of the present application, and not to be construed as limiting the scope of the application. For those skilled in the art, the present application may have various modifications and variations. Any modification, equivalent substitution, improvement, etc. made within the spirit and principles of the present application shall be included within the scope of the present application.

Industrial applicability can be illustrated as follows.

The present application provides a tunnel oxide layer, an N-type bifacial crystalline silicon solar cell and a method for manufacturing the same, and the present application relates to the field of crystalline silicon solar cells. The method for manufacturing the tunnel oxide layer can include forming excess -OH on a back side of a silicon wafer, and depositing the tunnel oxide layer on the back side of the silicon wafer by a Plasma Enhanced Atomic Layer Deposition method. The method for manufacturing the N-type bifacial crystalline silicon solar cell can include following steps: performing cleaning, texturing, boron diffusing, and alkaline polishing on an N-type silicon wafer, sequentially forming a P-type doped layer, a passivation layer, and an anti-reflection layer on a front side of the alkaline-polished N-type silicon wafer, and forming a tunnel oxide layer on a back side of the alkaline-polished N-type silicon wafer, followed by forming an N-type doped polysilicon layer, and after annealing, forming an anti-reflection layer. A SiOₓ layer obtained by the above method can be continuous and dense, and have a fast growth rate, an excellent impurity absorption effect and an excellent blocking effect. Moreover, a film thickness of the SiOₓ layer can be accurate and controllable, and the SiOₓ layer has pinholes with a high density and a large size after high temperature annealing.

In addition, it can be understood that the tunnel oxide layer, the N-type bifacial crystalline silicon solar cell and the method for manufacturing the same can be reproduced and applied in a variety of industries. For example, the tunnel oxide layer, the N-type bifacial crystalline silicon solar cell and the method for manufacturing the same can be applied in the field of crystalline silicon solar cells.

## Claims

1. A method for manufacturing a tunnel oxide layer, comprising following steps:
forming excess -OH on a back side of a silicon wafer; and
depositing a tunnel oxide layer on the back side of the silicon wafer by Plasma Enhanced Atomic Layer Deposition method.

2. The method of claim 1, wherein the forming excess -OH comprises:
cleaning the silicon wafer by using an alkaline solution during an alkaline polishing process after boron diffusing, wherein the alkaline solution is prepared by mixing NaOH or KOH with H₂O₂.

3. The method of claim 1, wherein the Plasma Enhanced Atomic Layer Deposition method further comprises following steps:
S1, introducing a silicon precursor to adsorb silicon atoms on the back side of the silicon wafer, followed by argon gas purging to remove excess silicon atoms, and leaving a layer of silicon atoms adsorbed on the back side of the silicon wafer;
S2, introducing an oxygen source and, under an influence of an electric field generated by a radio frequency power supply, depositing a SiOₓ film on the back side of the silicon wafer; and
S3, repeating steps S1 and S2 to form the tunnel oxide layer.

4. The method of claim 3, wherein the radio frequency power supply is a square wave or a sine wave power supply with a frequency of 40 kHz to 400 kHz.

5. The method of claims 3 or 4, wherein a deposition temperature of depositing the SiOₓ film is in a range of 80 °C to 400 °C; and/or
the silicon precursor is an organosilicon source or a silane, and the oxygen source is oxygen or nitrous oxide.

6. The method of claim 3, wherein the number of depositing the SiOₓ film is 1 to 400 times, and/or, a thickness of the tunnel oxide layer is in a range of 1 nm to 2 nm.

7. A method for manufacturing an N-type bifacial crystalline silicon solar cell, comprising following steps:
performing cleaning, texturing, boron diffusing, and alkaline polishing on an N-type silicon wafer;
sequentially forming a P-type doped layer, a passivation layer, and an anti-reflection layer on a front side of the alkaline-polished N-type silicon wafer; and
forming a tunnel oxide layer on a back side of the alkaline-polished N-type silicon wafer by using the method of any one of claims 1-6, followed by forming an N-type doped polysilicon layer, and after annealing and cleaning, forming an anti-reflection layer.

8. The method of claim 7, further comprising:
forming a front electrode on the anti-reflection layer located on the front side of the N-type silicon wafer and a back electrode on the anti-reflection layer located on the back side of the N-type silicon wafer.

9. The method of claims 7 or 8, wherein an annealing temperature is in a range of 850 °C to 1100 °C.

10. The method of any one of claims 7-9, wherein a method of alkaline polishing comprises: sequentially performing pre-cleaning, rinsing, etching, rinsing, alkali washing, rinsing, acid washing, and rinsing,
wherein an alkali solution is used in the alkali washing, the alkali solution is prepared by mixing NaOH or KOH with H₂O₂ with a volume ratio of 1 : 9 to 1 : 10, and a temperature of the alkali washing is in a range of 45 °C to 55 °C.

11. The method of any one of claims 7-10, wherein the passivation layer on a front side of the P-type doped layer is made of aluminum oxide deposited by using Plasma-Enhanced Atomic Layer Deposition (PEALD) method, wherein a radio frequency power supply of PEALD is a frequency of 40 kHz, and a deposition temperature of PEALD is 430 °C.

12. The method of claim 11, wherein the anti-reflection layer comprises multi layers containing silicon nitride with different refractive indexes, which are deposited using Plasma-Enhanced Chemical Vapor Deposition (PECVD) method on a front side of the passivation layer made of aluminum oxide.

13. The method of any one of claims 7-11, wherein the anti-reflection layer comprises silicon nitride and is prepared on a back side of the N-type doped polysilicon layer.

14. The method of claim 8, wherein the front electrode is formed on the anti-reflection layer located on the front side of the N-type silicon wafer by printing a silver-aluminum paste, and the back electrode is formed on the anti-reflection layer located on the back side of the N-type silicon wafer.

15. An N-type bifacial crystalline silicon solar cell, comprising:
an N-type silicon wafer;
a P-type doped layer, a passivation layer, and an anti-reflection layer sequentially stacked on a front side of the N-type silicon wafer; and
a tunnel oxide layer, an N-type doped polysilicon layer, and an anti-reflection layer sequentially stacked on a back side of the N-type silicon wafer,
wherein the tunnel oxide layer is manufactured by the method of any one of claims 1-6.
